# EUROPEAN PATENT APPLICATION

(11) **EP 4 786 060 A1**
(43) Date of publication of application: **05.08.2026**
(21) Application number: 23955894.3
(22) Date of filing: 22.11.2023
(51) Int. Cl.: B06B 1/02, G01B 17/02, H03K 17/74

(54) **ULTRASONIC ELECTRONIC EQUIPMENT CIRCUIT FOR ISOLATING HIGH-VOLTAGE TRANSMISSION FROM SMALL SIGNAL RECEPTION**

(30) Priority: 16.10.2023 CN 202311330795
(71) Applicant: Suzhou Phaserise Technology Co., Ltd., Suzhou, Jiangsu 215123 (CN)
(72) Inventor: JIN, Yisheng, Suzhou Jiangsu 215123 (CN); XIE, Mingming, Suzhou Jiangsu 215123 (CN); YANG, Long, Suzhou Jiangsu 215123 (CN)
(74) Representative: Sun, Yiming
(86) International application number: PCT/CN2023/133115
(87) International publication number: WO 2025/081576

(57) **Abstract**

Disclosed in the present invention is an ultrasonic electronic equipment circuit for isolating high-voltage transmission from small signal reception, which is characterized by comprising a diode bias current control circuit and a diode interconnection circuit, the diode bias current control circuit being used for controlling and regulating the current flowing through diodes in the diode interconnection circuit, and the diode interconnection circuit being used for isolating a high-voltage power output network from an input network of a small signal receiving circuit or connecting a transducer output network to the input network of the small signal receiving circuit. The present invention uses program control to enable or disenable the direct-current bias current of two diodes connected in series so as to turn off and turn on the diodes; when the direct-current bias current of the diodes are disenabled, the diodes are turned off so as to isolate a high-voltage power supply from the receiving circuit; when the direct-current bias current of the two diodes are enabled, the diodes are turned on and have very low alternating current impedance, so as to communicate an output signal of an ultrasonic transducer to the small signal receiving circuit at very low impedance.

## Description

### TECHNICAL FIELD

The present invention relates to the technical field of ultrasonic measurement, in particular to an ultrasonic electronic equipment circuit for isolating high-voltage emission from small-signal reception.

### BACKGROUND

In some industrial ultrasonic testing scenarios, higher ultrasonic emission power, simpler and more reliable transducer structures, and more sensitive signal reception electronic circuits are needed. These objectives are in a mutually restrictive relationship with regard to technical parameters. Sometimes, in order to meet the technical index requirements of one of them, it is necessary to sacrifice technical indexes of others. For example, if ultrasonic emission power is increased, it typically enlarges a dead zone of a received signal and increases the size of an electronic circuit. To reduce the dead zone of the signal, splitting a transducer into two physical parts, namely emission and reception parts, also enhances the structural complexity of the transducer. Improving signal sensitivity merely by increasing the gain of signal reception also simultaneously increases signals of noise. Meeting application purposes of end users of ultrasonic testing equipment needs finding a balance point among numerous technical indexes.

In a self-emitting and self-receiving ultrasonic testing electronic system, a received signal is typically 2 to 6 orders of magnitude lower than an emitted signal. Therefore, the emitted signal is considered a high-voltage signal relative to any received signal. Thus, a circuit module that isolates high-voltage emission from small-signal reception is particularly important.

Electromagnetic ultrasonic testing equipment is taken as an example, an existing electromagnetic ultrasonic technology needs adopting a high-power high-voltage power supply to excite a transducer placed in a constant magnetic field and on the surface of a workpiece, and thus ultrasonic waves are generated on the surface of the workpiece. The ultrasonic waves propagate within the workpiece. The reflected ultrasonic waves pass again through a transducer coil placed in the constant magnetic field, generating a weak voltage signal, which is input into a backend small-signal processing circuit. A testing result is obtained after analog conditioning and software analysis. A high voltage generated by an emission circuit is typically at the order of 100 V, while a small signal generated by a reception circuit is typically at the order of 10 µV. It is evident that the interference from the high-voltage emission circuit to the small-signal reception circuit may be extremely significant. Therefore, the high-power high-voltage power supply needs to be isolated from the backend low-signal processing circuit, while the transducer coil and the backend low-signal circuit need to maintain an effective low-impedance connection path.

Existing mainstream piezoelectric ultrasonic electronic equipment and electromagnetic ultrasonic electronic equipment adopt a damping-limiting method to isolate a high voltage and output a small signal. The specific implementation method is as follows: a resistor of several hundred ohms is connected in series between a high-voltage power supply and an input terminal of a small-signal reception circuit, a pair of fast-recovery small-signal diodes connected in reverse parallel is grounded at a junction of the resistor and the input terminal of the small-signal reception circuit, and the resistor bears the vast majority of a high-voltage drop, while the pull-down diodes clamp a residual high voltage at the small-signal input terminal within a safe range.

The drawback of the damping limiting is as follows: because the resistor of several hundred ohms is connected in series between the output of a transducer and the input of the small-signal reception circuit, equivalent output impedance of the transducer is increased, and a signal-to-noise ratio at a signal source end is reduced, which leads to an overall decrease in a signal-to-noise ratio of an entire instrument.

Fully focused piezoelectric phased array testing equipment is taken as another example, and each measurement of every array element requires a self-emitting and self-receiving measurement. If an emission voltage is too high, a small-signal dead zone also becomes too large, which results in the loss of important information about near-surface defects in a sample piece.

### SUMMARY

In view of the existing technical problems above, the objective of the present invention is to provide an ultrasonic electronic equipment circuit for isolating high-voltage emission from small-signal reception to replace the adoption of a method of a series resistor and a limiting diode for isolating a high voltage output by a high-voltage power supply from a small-signal reception circuit, which reduces equivalent output impedance of a transducer, enhances a signal-to-noise ratio, and simultaneously reduces a signal dead zone of the self-emitting and self-receiving ultrasonic transducer.

The technical solution of the present disclosure is as follows:
the ultrasonic electronic equipment circuit for isolating high-voltage emission from small-signal reception includes a diode bias current control circuit and a diode interconnection circuit;
the diode bias current control circuit is configured to control and regulate a current flowing through a diode in the diode interconnection circuit; and
the diode interconnection circuit is configured to isolate a high-power high-voltage power supply output circuit from an ultrasonic signal reception circuit and connect a transducer output network to the ultrasonic signal reception circuit.

Preferably, the diode interconnection circuit includes diodes D1, D2, D11, and D12, and resistors R1 and R5, wherein first terminals of the resistors R1 and R5 are jointly connected to a control terminal of the diode bias current control circuit; second terminals of the resistors R1 and R5 are connected to two terminals of a high-voltage power supply output network via the diodes D1 and D11 respectively; and the second terminals of the resistors R1 and R5 are further connected to two terminals of an input network of the ultrasonic signal reception circuit via the diodes D2 and D12 respectively.

Preferably, a Type I circuit or a Type II circuit is adopted as the diode interconnection circuit;
in the Type I circuit: cathodes of the diodes D1 and D2 are jointly connected to the resistor R1, and cathodes of the diodes D11 and D12 are jointly connected to the resistor R5; anodes of the diodes D1 and D11 are respectively connected to the two terminals of the high-voltage power supply output network; and anodes of the diodes D2 and D12 are respectively connected to the two terminals of the input network of the ultrasonic signal reception circuit; and
in the Type II circuit: the anodes of the diodes D1 and D2 are jointly connected to the resistor R1, and the anodes of the diodes D11 and D12 are jointly connected to the resistor R5; the cathodes of the diodes D1 and D11 are respectively connected to the two terminals of the high-voltage power supply output network; and the cathodes of the diodes D2 and D12 are respectively connected to the two terminals of the input network of the ultrasonic signal reception circuit.

Preferably, the diode bias current control circuit includes a transistor Q1, static bias resistors R2 and R3, and a negative feedback resistor R4, wherein the static bias resistors R2 and R3 are connected in series, the other terminal of R2 is grounded, and the other terminal of R3 is connected to a -VCC voltage in the Type I circuit and connected to a +VCC voltage in the Type II circuit; a base of the transistor Q1 is connected to a joint junction of R2 and R3, an emitter is connected to one terminal of R4, the other terminal of R4 is connected to a VEE power supply controlled by a system processor, the VEE power supply outputs 0 V or -VCC in the Type I circuit and outputs 0 V or +VCC in the Type II circuit, and a collector is connected to a control terminal of the diode interconnection circuit.

Preferably, when the transducer output network includes electromagnetic transducers L1_1 and L1_2,
in the Type I circuit, one terminals of the electromagnetic transducers L1_1 and L1_2 are connected to anodes of the diodes D1 and D11 respectively, and the other terminals of the electromagnetic transducers L1_1 and L1_2 are jointly grounded; and
in the Type II circuit, one terminals of the electromagnetic transducers L1_1 and L1_2 are connected to cathodes of the diodes D1 and D11 respectively, and the other terminals of the electromagnetic transducers L1_1 and L1_2 are jointly grounded.

Preferably, when the transducer output network includes piezoelectric transducers Y1_1 and Y1_2,
in the Type I circuit, one terminals of the piezoelectric transducers Y1_1 and Y1_2 are connected to the anodes of the diodes D1 and D11 respectively, and the other terminals of the piezoelectric transducers Y1_1 and Y1_2 are jointly grounded; and
in the Type II circuit, one terminals of the piezoelectric transducers Y1_1 and Y1_2 are connected to the cathodes of the diodes D1 and D11 respectively, and the other terminals of the piezoelectric transducers Y1_1 and Y1_2 are jointly grounded.

Preferably, when the system processor controls a VEE power supply to output 0V, the transistor Q1 in the diode bias current control circuit is turned off, the collector does not provide a quiescent current output, diodes in the diode interconnection circuit do not have a forward bias current, an anode-to-anode branch of the two series diodes and a branch from cathodes of the two series diodes to the emitter of the transistor are both in a turned-off isolation state, and at this point, the system processor controls a high-voltage emission power supply to output a high-voltage pulse, which passes through a low-impedance transducer coil to ground to form a loop, thereby completing the high-voltage emission; and
after a high-voltage emission period ends, the system processor controls an output of the VEE power supply, VEE outputs -VCC in the Type I circuit and outputs +VCC in the Type II circuit, the transistor Q1 in the diode bias current control circuit is turned on, the negative feedback resistor R4 stabilizes a quiescent operating current of Q1, the collector provides a constant quiescent current output, the diodes in the diode interconnection circuit generate a bias current, for an alternating-current small signal output by a transducer, the two series diodes are in a turned-on state, and at this point, the transducer and two input terminals of the ultrasonic signal reception circuit are in a turned-on connected state, so that reception of an ultrasonic echo is completed.

Compared with the prior art, the present invention has the following advantages.
1. The present invention adopts the novel high-voltage isolation and low-impedance small-signal output interface circuit, and adopts program control to enable or disenable a direct-current bias current of the two series diodes so as to turn off and turn on the diodes, thus simultaneously achieves isolation of the high-voltage power supply from the small-signal reception circuit and low-impedance connectivity between the transducer and the small-signal reception circuit, and based on the prior art, reduces the equivalent output impedance of the transducer and improves the signal-to-noise ratio of a system.
2. The present invention achieves a circuit structure design in which the diode interconnection circuit implements high-impedance isolation and low-impedance connectivity at different times.
3. The present invention achieves rapid turning-on and rapid turning-off of the diode bias current control circuit.

### BRIEF DESCRIPTION OF THE DRAWINGS

The present invention is further described below in conjunction with accompanying drawings and embodiments.
FIG. 1 is a schematic diagram of a high-voltage isolation Type I circuit connected to an electromagnetic transducer in Embodiment 1.
FIG. 2 is a schematic diagram of a high-voltage isolation Type II circuit connected to an electromagnetic transducer in Embodiment 1.
FIG. 3 is a schematic diagram of a high-voltage isolation Type I circuit connected to a piezoelectric transducer in Embodiment 2.
FIG. 4 is a schematic diagram of a high-voltage isolation Type II circuit connected to a piezoelectric transducer in Embodiment 2.
FIG. 5 shows a thickness measurement signal from an electromagnetic ultrasonic transducer of a damping-limiting high-voltage isolation circuit in Embodiment 4.
FIG. 6 shows a thickness measurement signal taken at the same location of the same sample by an electromagnetic ultrasonic transducer of a high-voltage isolation circuit in Embodiment 4.
FIG. 7 shows a thickness measurement signal from a piezoelectric ultrasonic transducer of a damping-limiting high-voltage isolation circuit in Embodiment 5.
FIG. 8 shows a thickness measurement signal taken at the same location of the same sample by a piezoelectric ultrasonic transducer of a high-voltage isolation circuit in Embodiment 5.

### DETAILED DESCRIPTION

In order to make objectives, technical solutions and advantages of the present invention clearer, the present invention is further explained in detail below in conjunction with specific implementations and with reference to accompanying drawings. It should be understood that these descriptions are merely exemplary, and are not intended to limit the scope of the present invention. In addition, in the following explanations, descriptions of well-known structures and technologies are omitted to avoid unnecessarily obscuring the concept of the present invention.

### Embodiment 1

An ultrasonic electronic equipment circuit for isolating high-voltage emission from small-signal reception of the present invention includes a diode bias current control circuit and a diode interconnection circuit; the diode bias current control circuit is configured to control and regulate a current flowing through a diode in the diode interconnection circuit; and the diode interconnection circuit is configured to isolate a high-voltage power supply output network from an input network of a small-signal reception circuit or connect a transducer output network to the input network of the small-signal reception circuit.

The diode interconnection circuit includes diodes D1, D2, D11, and D12, and resistors R1 and R5, wherein first terminals of the resistors R1 and R5 are jointly connected to a control terminal of the diode bias current control circuit; second terminals of the resistors R1 and R5 are connected to two terminals of the high-voltage power supply output network via the diodes D1 and D11 respectively; and the second terminals of the resistors R1 and R5 are further connected to two terminals of the input network of the ultrasonic signal reception circuit via the diodes D2 and D12 respectively.

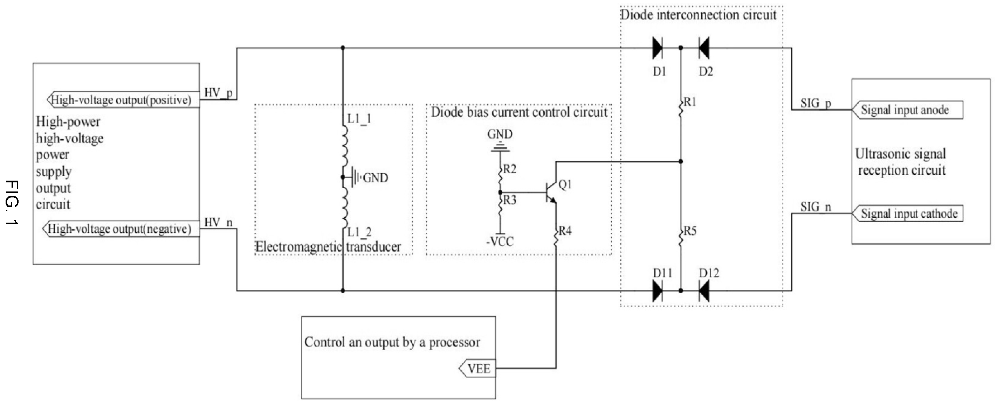

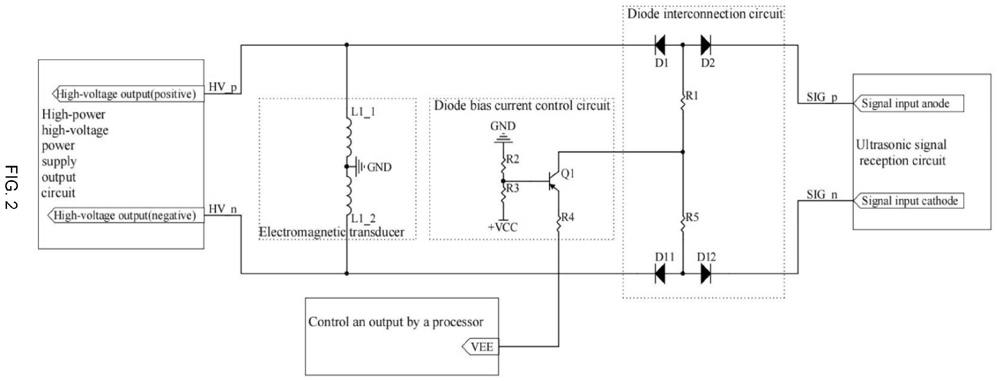

As shown in FIGS. 1 and 2, a Type I circuit and a Type II circuit are adopted as the diode interconnection circuit respectively.

In the Type I circuit in FIG. 1: cathodes of the diodes D1 and D2 are jointly connected to the resistor R1, and cathodes of the diodes D11 and D12 are jointly connected to the resistor R5; anodes of the diodes D1 and D11 are respectively connected to the two terminals of the high-voltage power supply output network; and anodes of the diodes D2 and D12 are respectively connected to the two terminals of the input network of the ultrasonic signal reception circuit.

In the Type II circuit in FIG. 2: the anodes of the diodes D1 and D2 are jointly connected to the resistor R1, and the anodes of the diodes D11 and D12 are jointly connected to the resistor R5; the cathodes of the diodes D1 and D11 are respectively connected to the two terminals of the high-voltage power supply output network; and the cathodes of the diodes D2 and D12 are respectively connected to the two terminals of the input network of the ultrasonic signal reception circuit.

The diode bias current control circuit includes a high-voltage bipolar transistor Q1, static bias resistors R2 and R3, and a negative feedback resistor R4, wherein the static bias resistors R2 and R3 are connected in series, the other terminal of R2 is grounded, and R3 is connected to a -12 V voltage in the Type I circuit and connected to a +12 V voltage in the Type II circuit. A base of the high-voltage bipolar transistor Q1 is connected to a joint junction of R2 and R3, an emitter is connected to one terminal of R4, the other terminal of R4 is connected to a VEE power supply controlled by a system processor, the VEE power supply outputs 0 V or -12 V in the Type I circuit and outputs 0 V or +12 V in the Type II circuit, and a collector is connected to a control terminal of the diode interconnection circuit. By controlling the output of the VEE power supply, an operating state of Q1 is rapidly controlled: Q1 is turned off or Q1 provides a constant current output, in the two states of Q1, the collector of Q1 outputs different bias currents, and thus a forward bias current of the diodes in the diode interconnection circuit is ultimately controlled.

The anodes of the diodes D1 and D11 are further connected to the two terminals of the transducer output network respectively. The transducer output network includes electromagnetic transducers L1_1 and L1_2. One terminals of the electromagnetic transducers L1_1 and L1_2 are connected to the anodes of the diodes D1 and D11 respectively, and the other terminals of the electromagnetic transducers L1_1 and L1_2 are jointly grounded. The anodes of D2 and D12 are connected to the two terminals of the input network of the ultrasonic signal reception circuit respectively.

### Embodiment 2

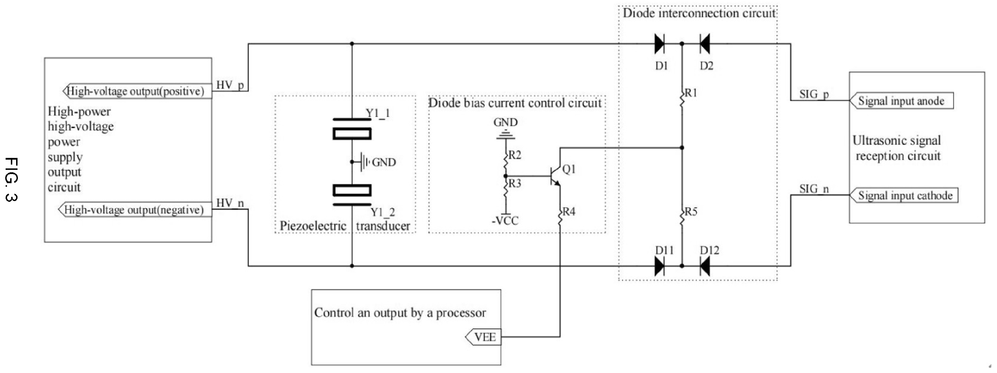

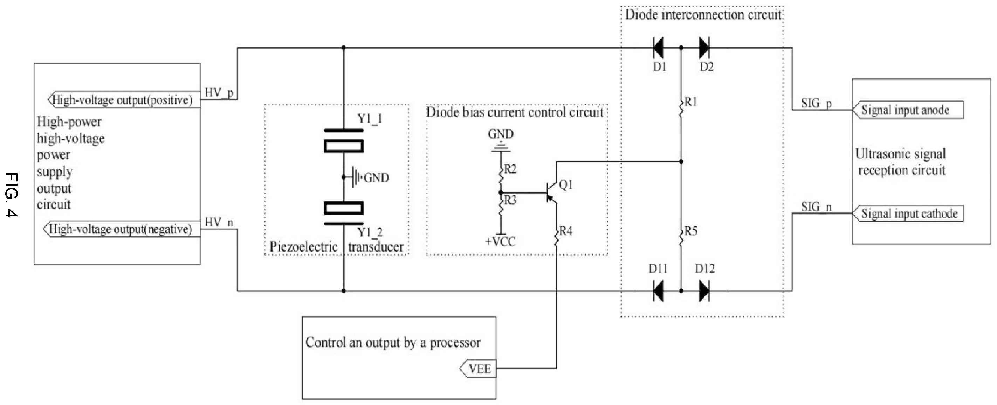

As shown in FIGS. 3 and 4, in an ultrasonic electronic equipment circuit for isolating high-voltage emission from small-signal reception of this embodiment, a transducer output network includes piezoelectric transducers Y1_1 and Y1_2. One terminals of the piezoelectric transducers Y1_1 and Y1_2 are connected to anodes of diodes D1 and D11 respectively, and the other terminals of the piezoelectric transducers Y1_1 and Y1_2 are jointly grounded. Anodes of D2 and D12 are connected to two terminals of an input network of an ultrasonic signal reception circuit respectively.

### Embodiment 3

Referring to the circuit solution of Embodiment 1 shown in FIGS. 1 and 2, this embodiment describes an operating process of a high-voltage isolation and transducer low-loss output circuit as follows.
(1) A system processor controls VEE to output 0 V. An emitter voltage of a transistor Q1 is 0 V, and a base voltage of Q1 is set by bias resistors R2 and R3. In a Type I circuit, the base voltage of Q1 is -11.04 V, and in a Type II circuit, the base voltage of Q1 is +11.04 V. At this point, an emitter junction of Q1 is reverse-biased, a collector junction is reverse-biased, and Q1 enters into a turned-off state. A collector of Q1 does not have an effective and constant current output, and diodes D1, D2, D11, and D12 do not have an effective direct bias current either. Therefore, the impedance of the paths from the anode of D1 to the anode of D2 and from the anode of D11 to the anode of D12 is high for both alternating and direct current signals. At this point, a high-voltage pulse output by a high-voltage power supply controlled by the system processor can only pass through a transducer coil to ground to form a loop, thereby completing high-voltage emission this time.
(2) After the high-voltage emission ends, the system processor controls the VEE output. In the Type I circuit, the VEE output is -12 V. in the Type II circuit, the VEE output is +12 V. The emitter voltage of the transistor Q1 is -11.65 V in the Type I circuit and +11.65 V in the Type II circuit. At this point, the emitter junction of Q1 is forward-biased, the collector junction is reverse-biased, and Q1 enters into a linear amplification state. R4 converts an emitter current of Q1 into a voltage that is connected in series with a base voltage of Q1, a negative feedback is formed to stabilize a quiescent operating current of Q1. The collector of Q1 outputs a constant current, and the current passes through four low-impedance paths to form direct-current loops as follows respectively: the current passes through R1 and D1, and an electromagnetic transducer L1_1 to ground; the current passes through R1 and D2, and an input terminal of an ultrasonic signal reception circuit to ground; the current passes through R5 and D11, and an electromagnetic transducer L1_2 to ground; and the current passes through R5 and D12, and the input terminal of the ultrasonic signal reception circuit to ground. At this point, the diodes D1, D2, D11, and D12 have a constant forward bias current. Relative to an alternating-current small signal output by the transducer, D1, D2, D11, and D12 are turned on and have very low impedance. Therefore, the transducer and the input terminal of the ultrasonic signal reception circuit achieve low-impedance connectivity through D1, D2, D11, and D12, and thus reception of an ultrasonic echo is completed.

### Embodiment 4

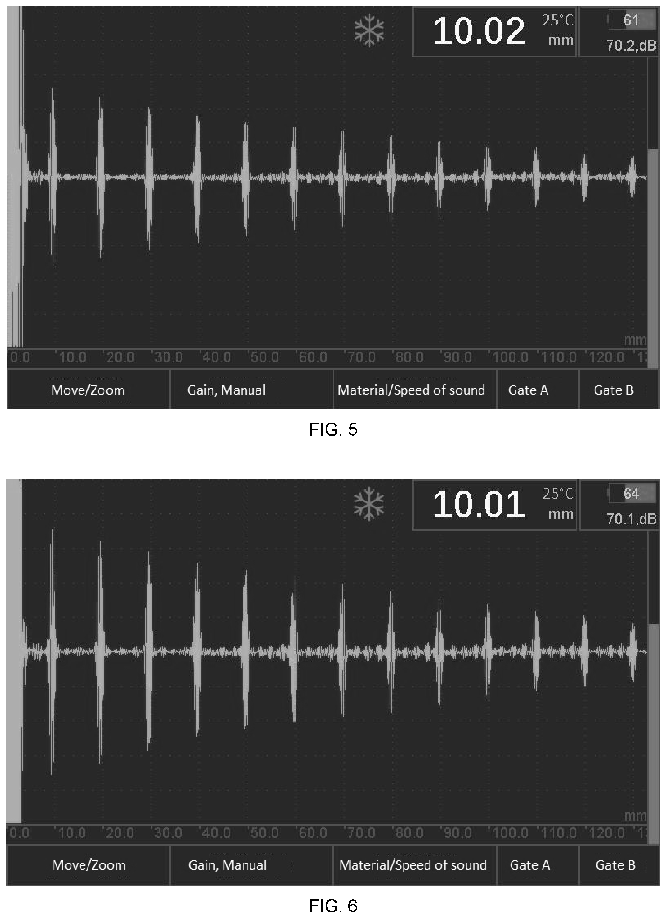

As shown in FIGS. 5 and 6, in this embodiment, a novel high-voltage isolation and transducer low-loss output circuit and a damping-limiting high-voltage isolation circuit are implemented together for an effect comparison. FIG. 5 shows a thickness measurement signal obtained by applying a damping-limiting circuit to an electromagnetic ultrasonic transducer. FIG. 6 shows a thickness measurement signal obtained by applying a novel high-voltage isolation and transducer low-loss output circuit disclosed in the present invention. It can be seen that a signal amplitude is increased after the novel high-voltage isolation and transducer low-loss output circuit disclosed in the present invention is adopted.

### Embodiment 5

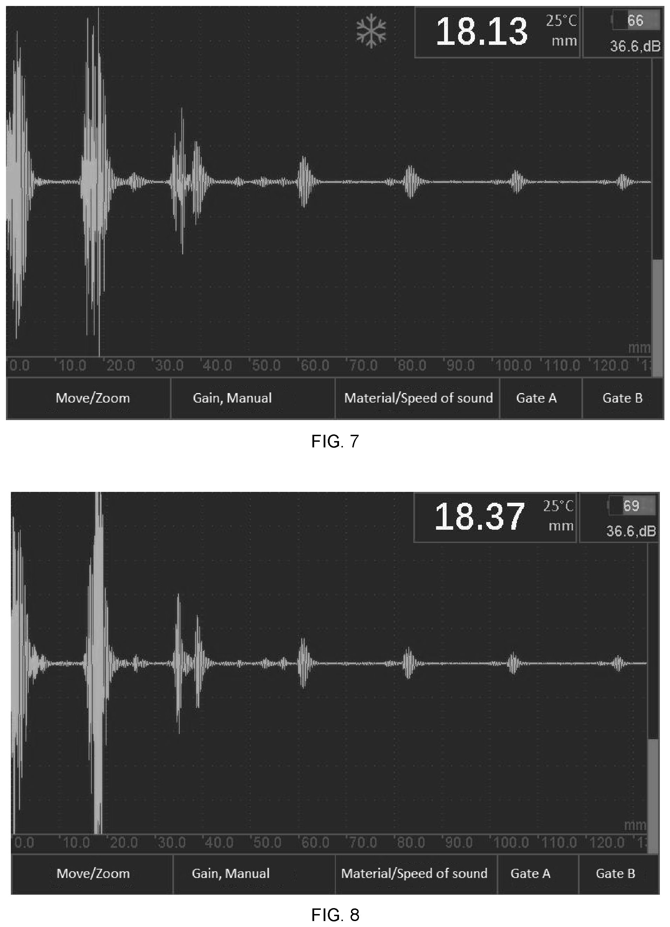

As shown in FIGS. 7 and 8, in this embodiment, a novel high-voltage isolation and transducer low-loss output circuit and a damping-limiting high-voltage isolation circuit are implemented together for an effect comparison. FIG. 7 shows a thickness measurement signal obtained by applying a damping-limiting circuit to two piezoelectric ultrasonic transducers connected in series. FIG. 8 shows a thickness measurement signal obtained by applying a novel high-voltage isolation and transducer low-loss output circuit disclosed in the present invention. A first wave and a periodic wave it generates represent matching layer signals, while other waves represent effective thickness signals. It can be seen that a signal amplitude is increased after the novel high-voltage isolation and transducer low-loss output circuit disclosed in the present invention is adopted.

It should be understood that the above specific implementations of the present invention are merely used for illustrative explanations or to clarify the principles of the present invention, and do not constitute a limitation on the present invention. Thus, any modifications, equivalent substitutions, improvements, etc. made without departing from the spirit and scope of the present invention should be included within the scope of protection of the present invention. In addition, the appended claims of the present invention are intended to cover all variations and modification examples falling within the scope and boundaries of the appended claims, or within the equivalents of such scope and boundaries.

## Claims

1. An ultrasonic electronic equipment circuit for isolating high-voltage emission from small-signal reception, **characterized by** comprising a diode bias current control circuit and a diode interconnection circuit;
wherein the diode bias current control circuit is configured to control and regulate a current flowing through a diode in the diode interconnection circuit; and
the diode interconnection circuit is configured to isolate a high-power high-voltage power supply output circuit from an ultrasonic signal reception circuit and connect a transducer output network to the ultrasonic signal reception circuit.

2. The ultrasonic electronic equipment circuit for isolating high-voltage emission from small-signal reception according to claim 1, **characterized in that** the diode interconnection circuit comprises diodes D1, D2, D11, and D12, and resistors R1 and R5, wherein first terminals of the resistors R1 and R5 are jointly connected to an output terminal of the diode bias current control circuit; second terminals of the resistors R1 and R5 are connected to two terminals of a high-voltage power supply output network via the diodes D1 and D11 respectively; and the second terminals of the resistors R1 and R5 are further connected to two terminals of an input network of the ultrasonic signal reception circuit via the diodes D2 and D12 respectively.

3. The ultrasonic electronic equipment circuit for isolating high-voltage emission from small-signal reception according to claim 2, **characterized in that** a Type I circuit or a Type II circuit is adopted as the diode interconnection circuit;
in the Type I circuit: cathodes of the diodes D1 and D2 are jointly connected to the resistor R1, and cathodes of the diodes D11 and D12 are jointly connected to the resistor R5; anodes of the diodes D1 and D11 are respectively connected to the two terminals of the high-voltage power supply output network; and anodes of the diodes D2 and D12 are respectively connected to the two terminals of the input network of the ultrasonic signal reception circuit; and
in the Type II circuit: the anodes of the diodes D1 and D2 are jointly connected to the resistor R1, and the anodes of the diodes D11 and D12 are jointly connected to the resistor R5; the cathodes of the diodes D1 and D11 are respectively connected to the two terminals of the high-voltage power supply output network; and the cathodes of the diodes D2 and D12 are respectively connected to the two terminals of the input network of the ultrasonic signal reception circuit.

4. The ultrasonic electronic equipment circuit for isolating high-voltage emission from small-signal reception according to claim 1, **characterized in that** the diode bias current control circuit comprises a transistor Q1, static bias resistors R2 and R3, and a negative feedback resistor R4, wherein the static bias resistors R2 and R3 are connected in series, common terminals are connected to a base of the transistor Q1, the other terminal of R2 is grounded, and the other terminal of R3 is connected to a -VCC voltage in the Type I circuit and connected to a +VCC voltage in the Type II circuit; and an emitter of the transistor Q1 is connected to one terminal of R4, the other terminal of R4 is connected to a VEE power supply controlled by a system processor, the VEE power supply outputs 0 V or -VCC in the Type I circuit and outputs 0 V or +VCC in the Type II circuit, and a collector of the transistor Q1 is connected to a control terminal of the diode interconnection circuit.

5. The ultrasonic electronic equipment circuit for isolating high-voltage emission from small-signal reception according to claim 1, **characterized in that** the transducer output network comprises electromagnetic transducers L1_1 and L1_2 or piezoelectric transducers Y1_1 and Y1_2.

6. The ultrasonic electronic equipment circuit for isolating high-voltage emission from small-signal reception according to claim 5, **characterized in that** when the transducer output network comprises the electromagnetic transducers L1_1 and L1_2, in a Type I circuit, one terminals of the electromagnetic transducers L1_1 and L1_2 are connected to anodes of diodes D1 and D11 respectively, and the other terminals of the electromagnetic transducers L1_1 and L1_2 are jointly grounded; and in a Type II circuit, one terminals of the electromagnetic transducers L1_1 and L1_2 are connected to cathodes of the diodes D1 and D11 respectively, and the other terminals of the electromagnetic transducers L1_1 and L1_2 are jointly grounded.

7. The ultrasonic electronic equipment circuit for isolating high-voltage emission from small-signal reception according to claim 5, **characterized in that** when the transducer output network comprises the piezoelectric transducers Y1_1 and Y1_2, in a Type I circuit, one terminals of the piezoelectric transducers Y1_1 and Y1_2 are connected to anodes of diodes D1 and D11 respectively, and the other terminals of the piezoelectric transducers Y1_1 and Y1_2 are jointly grounded; and in a Type II circuit, one terminals of the piezoelectric transducers Y1_1 and Y1_2 are connected to cathodes of the diodes D1 and D11 respectively, and the other terminals of the piezoelectric transducers Y1_1 and Y1_2 are jointly grounded.

8. The ultrasonic electronic equipment circuit for isolating high-voltage emission from small-signal reception according to claim 1, **characterized in that** when a system processor controls a VEE power supply to output 0 V, a transistor Q1 in the diode bias current control circuit is turned off, a collector does not provide a quiescent current output, diodes in the diode interconnection circuit do not have a forward bias current, an anode-to-anode branch of the two series diodes and a branch from cathodes of the two series diodes to an emitter of the transistor are both in a turned-off isolation state, and at this point, the system processor controls a high-voltage emission power supply to output a high-voltage pulse, which passes through a low-impedance transducer coil to ground to form a loop, thereby completing the high-voltage emission; and
after a high-voltage emission period ends, the system processor controls an output of the VEE power supply, VEE outputs -VCC in a Type I circuit and outputs +VCC in a Type II circuit, the transistor Q1 in the diode bias current control circuit is turned on, a negative feedback resistor R4 stabilizes a quiescent operating current of Q1, the collector of Q1 provides a constant quiescent current output, the diodes in the diode interconnection circuit generate a bias current, for an alternating-current small signal output by a transducer, the two series diodes are in a turned-on state, and at this point, the transducer and two input terminals of the ultrasonic signal reception circuit are in a turned-on connected state, so that reception of an ultrasonic echo is completed.
